# EUROPÄISCHE PATENTSCHRIFT

(11) **EP 0 620 702 B1**
(45) Veröffentlichungstag und Bekanntmachung des Hinweises auf die Patenterteilung: **20.01.1999**
(21) Anmeldenummer: 94810179.5
(22) Anmeldetag: 23.03.1994
(51) Int. Cl.: H05K 3/40, H05K 3/46

(54) **Kern für elektrische Verbindungssubstrate und elektrische Verbindungssubstrate mit Kern, sowie Verfahren zu deren Herstellung**
Core for electrical interconnection substrates and electrical interconnection substrates with core, and method for manufacturing the same
Noyau pour des substrats d'interconnexion électrique et substrats d'interconnexion avec noyau, et leur procédé de fabrication

(30) Priorität: 16.04.1993 CH 1163/93
(43) Veröffentlichungstag der Anmeldung: 19.10.1994
(73) Patentinhaber: DYCONEX PATENTE AG, 6300 Zug (CH)
(72) Erfinder: Schmidt, Walter, CH-8050 Zürich (CH); Martinelli, Marco, CH-8413 Neftenbach (CH)
(74) Vertreter: Frei, Alexandra Sarah

(56) Entgegenhaltungen:
- WO-A-92/15408
- DE-A- 1 930 642
- DE-A- 3 709 770
- US-A- 3 488 429
- IBM TECHNICAL DISCLOSURE BULLETIN., Bd.16, Nr.5, Oktober 1973, NEW YORK US Seiten 1604 - 1605 A.W. CUMMINS ET AL. 'Two-side etching for thick films'
- IBM TECHNICAL DISCLOSURE BULLETIN., Bd.9, Nr.10, März 1967, NEW YORK US Seite 1297 M.M. HADDAD ET AL. 'High-density circuit board'

## Beschreibung

Die Erfindung liegt auf dem Gebiete der Herstellung von elektrischen Verbindungssubstraten, insbesondere Leiterplatten und Folienleiterplatten mit beidseitigen Leiterlagen, und betrifft einen Kern für elektrische Verbindungssubstrate und elektrische Verbindungssubstrate mit einem entsprechenden Kern nach den Oberbegriffen der entsprechenden, unabhängigen Patentansprüche, sowie Verfahren zu deren Herstellung nach den Oberbegriffen der entsprechenden, unabhängigen Verfahrensansprüche.

Die Druckschrift DE-A-3 709 770 zeigs eine Kernschicht gemäß dem Oberbegriff von Anspruch 1.

Leiterplatten herkömmlicher Art können viele bis sehr viele Leiterebenen aufweisen, die untereinander elektrisch verbunden sind durch gebohrte Löcher, die die gesamte Leiterplatte durchdringen. Diese Art der Z-Verbindung zwischen den Leiterebenen der Leiterplatte ist sinnvoll, wenn die Leiterplatte auch bestückt wird mit Bausteinen, deren Anschlussbeinchen in derartigen Durchgangslöchern eingelötet werden müssen. Die Grösse der Durchgangslöcher wird in diesem Falle bestimmt durch die Lötbeinchen und beträgt üblicherweise 0,7 bis 1 mm.

Im Falle einer Bestückung mit oberflächenmontierten Bausteinen (SMD-Technik) sind für die Bestückung keine derart grossen Löcher mehr notwendig, weshalb die Löcher für die Z-Verbindungen denn auch bis zu Durchmessern von 0,2 mm verkleinert wurden, wo etwa die untere Grenze von durch mechanisches Bohren herstellbaren Löchern liegt. Aber auch derartige Löcher und die damit verbundenen Lötaugen, die aus Toleranzgründen einen Durchmesser von 0,5 bis 1 mm haben, benötigen auch in Leiterebenen, die sie funktionell gar nicht berühren, relativ viel Platz. Ferner müssen sie sequentiell, das heisst zeitaufwendig, hergestellt werden. Das Bohren von derart kleinen Löchern ist ferner aufwendig, weil der Bohrervorschub entsprechend klein gehalten werden muss, weil keine Stapel von Platinen miteinander gebohrt werden können und weil die dünnen Bohrer einen raschen Verschleiss aufweisen. Dazu kommen Nachteile des Bohrens allgemein, das heisst, ein zusätzlicher Arbeitsschritt zum Entfernen der Bohrgrate und ein weiterer zum Entfernen des Bohrstaubes.

Um die Nachteile der gebohrten Löcher zu umgehen und auch um deren untere Durchmessergrenze unterschreiten zu können, sind beispielsweise in den Patentanmeldungen EP-92904744.7 (Veröffentlichungsnummer 0527980, P0619) und CH-01872/92-6 (P0655) derselben Anmelderin Verfahren zur Herstellung von Folienleiterplatten beschrieben, in denen die Z-Verbindungen zwischen den einzelnen Leiterebenen nicht mehr durch gebohrte Löcher verlaufen sondern durch Löcher, die in einem Trockenätzschritt (Plasmaätzen) hergestellt werden. Mit den beschriebenen Methoden können die Lochdurchmesser bedeutend herabgesetzt werden (das heisst Lochdurchmesser bis hinab zu 20 µm sind ohne weiteres möglich), können mit derselben Präzision auch Sacklöcher hergestellt werden, können neben runden Löchern auch Öffnungen beliebiger Formen erstellt werden, können tausende von Löchern gleichzeitig hergestellt werden usw.

Das in den beschriebenen Verfahren normalerweise verwendere Basismaterial sind sehr dünne Kunststoffolien, unter anderem deshalb, weil mit den verwendeten Trockenätzprozessen in einem Plasma in einer vertretbar kurzen Zeit nur Material mit einer Dicke von ca. 100 µm durchgeätzt werden kann. Diese Dünnheit des Materials hat Vorteile dadurch, dass viele Leiterebenen aufeinander gepackt werden können, ohne dass Leiterplatten extremer Dicke entstehen, sie hat aber auch den Nachteil, dass eine derartige Leiterplatte, wenn sie nicht viele Leiterebenen aufweist, mechanisch nicht steif ist, das heisst, dass sie auf einen Kern aufgezogen werden muss.

Derartige Kerne sind beispielsweise beschrieben in den Patentanmeldungen EP-91104096.2 (Veröffentlichungsnummer 0451541, P0391) und CH-00938/92-5 (P0620) derselben Anmelderin. Die beschriebenen Kerne weisen wiederum Bohrungen auf, die, wie oben für Leiterplatten erwähnt, durch aufwendige Bohrverfahren hergestellt werden müssen und die auch in den Folienlagen Platz beanspruchen.

Um die Vorteile, die die Folientechnik mit sich bringt, auch für elektrische Verbindungssubstrate mit Kern voll ausnützen zu können, sollte der Kern neben den Bedingungen der Eigensteifigkeit und der Verarbeitbarkeit mit dem Folienmaterial idealerweise auch die folgenden Wünsche erfüllen können:
- Damit das elektrische Verbindungssubstrat auf beiden Seiten Signalleitungen und eine Bestückung haben kann, sollte der Kern in Z-Richtung Signalverbindungen ermöglichen, die die Auslegung der Leiter in den Signalebenen möglichst wenig einengen und vor allem in diesen Ebenen keinen oder möglichst wenig Platz beanspruchen;
- Damit auch bei hohem Energieverbrauch die Bestückung des elektrischen Verbindungssubstrates möglichst eng sein kann, sollte der Kern die Verlustwärme der Bausteine gut ableiten.
- Damit das elektrische Verbindungssubstrat möglichst kostengünstig hergestellt werden kann, sollte der Kern ein kostengünstig herstellbares Universalprodukt sein, das neben der mechanischen Funktion möglichst auch noch andere universelle Funktionen (z.B. Servicefunktionen) übernehmen kann und das unabhängig von der Funktion des fertigen, elektrischen Verbindungssubstrats hergestellt und getestet werden kann.

Es ist nun die Aufgabe der Erfindung einen Kern für elektrische Verbindungssubstrate, insbesondere Leiterplatten und Folienleiterplatten mit beidseitigen Leiterlagen, aufzuzeigen, mit dem die obigen Wünsche an einen idealen derartigen Kern bedeutend besser erfüllt wird als mit Kernen für elektrische Verbindungssubstrate bekannter Art, das heisst mit gebohrten Löchern. Ferner ist es die Aufgabe der Erfindung, Verfahren aufzuzeigen, mit denen der erfindungsgemässe Kern und, ausgehend von diesem erfindungsgemässen Kern, elektrische Verbindungssubstrate, insbesondere Leiterplatten und Folienleiterplatten mit beidseitigen Leiterebenen mit möglichst wenig Aufwand hergestellt werden können.

Diese Aufgabe wird gelöst durch den Kern für elektrische Verbindungssubstrate und die Herstellungsverfahren, wie sie durch die Patentansprüche definiert sind.

Die erfindungsgemässe Kernschicht zur Weiterverarbeitung für elektrische Verbindungssubstrate weist eine Innenschicht mit einer Säulenstruktur auf und beidseitige metallische Deckschichten, wobei die Säulenstruktur aus einer Anordnung von voneinander und von den Deckschichten beabstandeten, quer zur flächigen Ausdehnung des Kernes gerichteten Säulen aus einem elektrisch leitfähigen Material (bspw. Kupfer) in einer Matrix aus einem elektrisch isolierenden Material (bspw. Kunststoff wie Polyimid, Epoxidharz etc.) besteht. Diese Säulenstruktur ist vorteilhafterweise regelmässig. Der mit isolierendem Material gefüllte Abstand zwischen der metallischen Deckschicht und den Säulen ist dabei derart, dass er in einem Trockenätzschritt (Plasmaätzung) in einer sinnvollen Zeit durchgeätzt werden kann (in der Gegend von 100 µm).

An einem derartigen Kern können für elektrische Durchführungen in Z-Richtung einfach an entsprechenden Stellen durch durchplattierte Sacklöcher die Deckschichten mit ausgewählten Säulen elektrisch verbunden werden.

Die Säulen können dabei sehr eng nebeneinander angeordnet sein, sodass sie nicht nur einen engen Raster für potentielle Durchführungen darstellen sondern auch einen Kern aus einem Material mit hohem metallischem Anteil, der gut wärmeableitend wirkt. Die Säulen können statt in einem regelmässigen Raster auch anwendungsspezifisch über den Kern verteilt sein.

Die metallischen Deckschichten des Kernes können zu universellen Leiterebenen strukturiert sein, die durch eine flächige Strukturierung als Serviceebenen geeignet sind und die derart ausgebildet und mit der Säulenstruktur verbunden sind, dass sie ein regelmässiges Raster für potentielle Signalverbindungen in Z-Richtung und Verbindungen zur gegenüberliegenden, entsprechenden Serviceebene aufweisen. Werden auf einen derartigen Kern beidseitig weitere Folien auflaminiert, können darauf angeordnete Leiter durch Sacklöcher mit den Rasterstellen des Kernes für entsprechende funktionelle Z-Verbindungen verbunden werden. Bei einer Beschaltung je einer der zwei Serviceebenen mit Erde und einer Speisespannung stehen durch die Säulenstruktur der Innenschicht und die Rasterstrukturierung der beiden Serviceebenen beidseitig neben Anschlüssen für Signalverbindungen auch Erde- und Versorgungsanschlüsse zur Verfügung, die aus darüber liegenden Leiterebenen entsprechend kontaktiert werden können.

Selbstverständlich können für einfachere Anwendungen die beiden metallischen Deckschichten des Kerns auch individuell (nicht universell, rasterartig) und/oder nicht ausschliesslich als Serviceebenen strukturiert und mit der Säulenstruktur verbunden werden.

Der erfindungsgemässe Kern kann aber auch beispielsweise mit keramischen Schaltungsträgern weiter verarbeitet werden. Dabei ist die Hauptfunktion des Kernes nicht die Versteifung der derart hergestellten Leiterplatte, sondern die elektrische Verbindung der beidseitigen Schaltungsebenen.

Zur Herstellung von Folienieiterplatten wird beispielsweise auf einen erfindungsgemässen Kern beidseitig mindestens eine Folienlage auflaminiert, die aus einer elektrisch isolierenden Zwischenschicht und einer Metallschicht besteht, wobei die Metallschicht als Leiterebene strukturiert wird und mit durchplattierten Sacklöchern durch die isolierende Schicht mit den Kontaktstellen des Oberflächenrasters des Kerns elektrisch verbunden wird.

Anhand der folgenden Figuren soll nun der erfindungsgemässe Kern und das Verfahren zu dessen Herstellung im Detail beschrieben werden. Dabei zeigen:
- **Figuren 1 bis 16**: verschiedene Stadien der Herstellung einer beispielhaften Ausführungsform des erfindungsgemässen Kerns für elektrische Verbindungssubstrate (Querschnitte);
- **Figur 17**: eine Draufsicht auf eine beispielhafte Ausführungsform des erfindungsgemässen Kerns für elektrische Verbindungssubstrate;
- **Figur 18**: eine dreidimensionale Ansicht eines geschnittenen Kerns gemäss Figur 17;
- **Figur 19**: einen Querschnitt durch einen Bereich einer Folienleiterplatte mit einem erfindungsgemässen Kern.

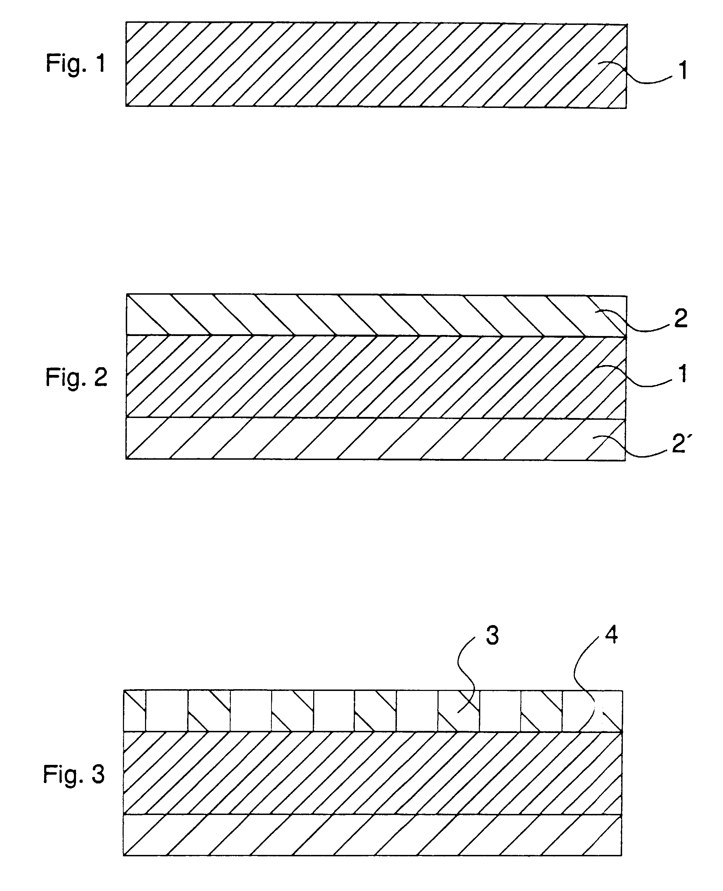

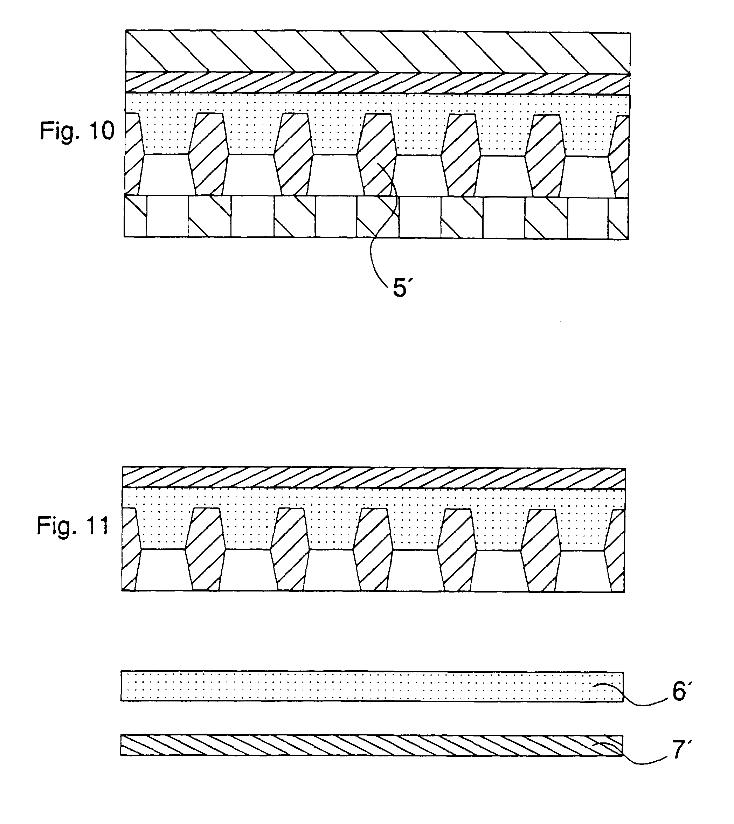

**Figuren 1 bis 16** zeigen verschiedene Stadien der Herstellung einer beispielhaften Ausführungsform des erfindungsgemässen Kerns für elektrische Verbindungssubstrate jeweils als Querschnitt durch einen Bereich des entstehenden Kerns. Das Ausgangsprodukt ist dabei beispielsweise eine Kupferfolie. Anstelle von Kupferfolien können auch kalt laminierte Compositfolien bestehend aus einer dickeren Aluminiumfolie und beidseitig darauf laminierten, dünneren Kupferfolien verwendet werden. Ebenfalls geeignete Ausgangsprodukte sind beispielsweise Folien aus rostfreiem Stahl, Messing, Bronze, Aluminium-Magnesium-Legierungen, Invar oder Molybdän.

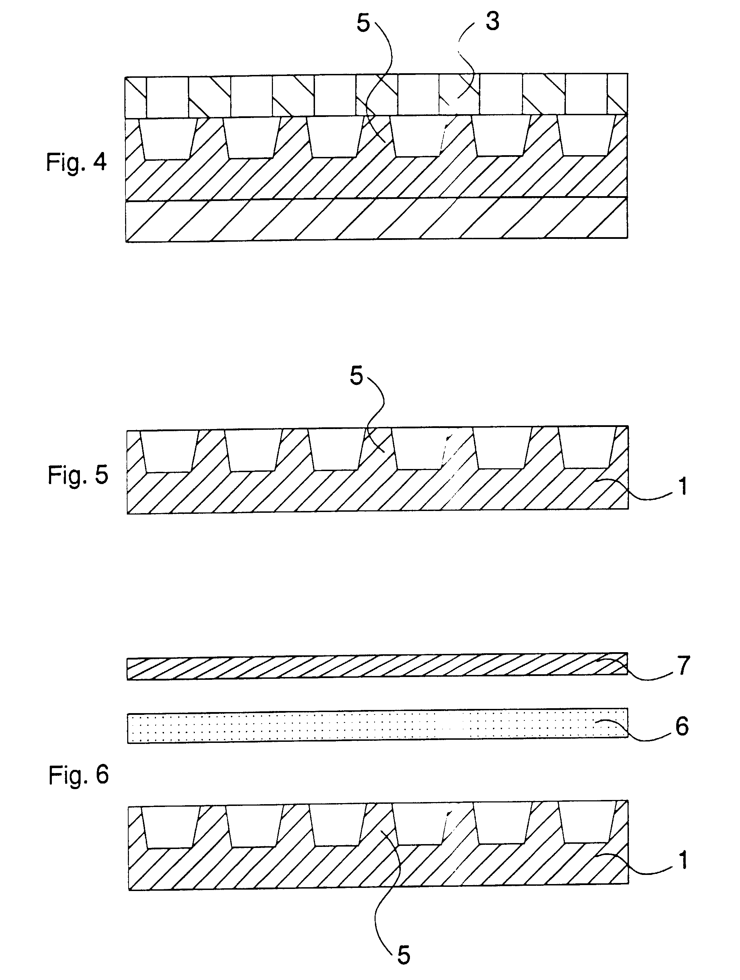

**Figur 1** zeigt das Ausgangsprodukt, das beispielsweise aus einer Kupferfolie 1 von 0,1 bis 1 mm Dicke besteht. Auf diese Kupferfolie 1 wird beidseitig Photoresist 2 und 2' aufgetragen, wie dies in **Figur 2** dargestellt ist. Die Photoresistschicht der einen Seite wird nun durch eine Maske belichtet und entwikkelt, derart, dass sich ein regelmässiges Muster von Resistinseln 3 und dazwischenliegenden Bereichen 4 von freigelegter Kupferoberfläche bildet, wie dies in **Figur 3** dargestellt ist. Die Resistinseln sind dabei beispielsweise rund, sie können aber auch andere Formen aufweisen. Nun wird die Folie mit üblichen Verfahren geätzt, wobei die Ätzparameter derart gewählt werden, dass die Kupferfolie etwa halb durchgeätzt wird, wie die **Figur 4** zeigt. Eine Unterätzung der Photoresistinseln 3 ist dabei kaum zu vermeiden, was bei deren Dimensionierung in Betracht gezogen werden muss. Der Photoresist wird nun von beiden Seiten des Kernes gestrippt, wodurch auf der bearbeiteten Seite eine Kupferoberfläche mit regelmässig angeordneten Erhöhungen 5 entsteht. Diese ist in der **Figur 5** gezeigt.

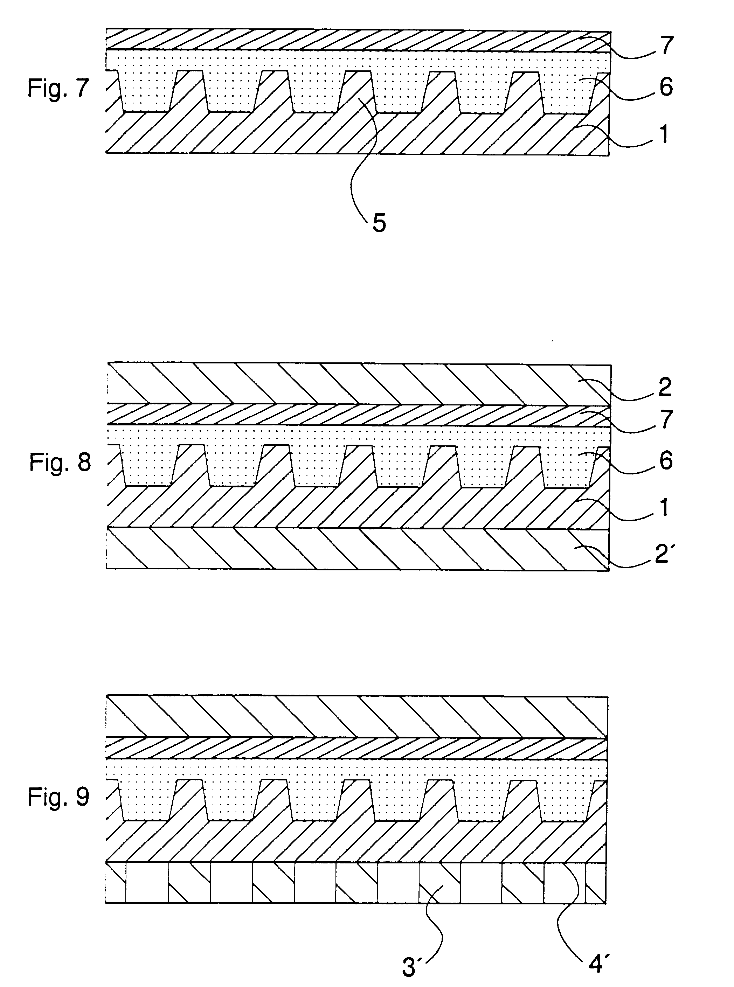

**Figur 6** zeigt, wie das einseitig bearbeitete Halbzeug nun mit einer Kleberfolie 6, beispielsweise aus Epoxidharz, wie sie auch zum Verkleben von starrflexiblen Leiterplatten verwendet wird, und einer dünnen Kupferfolie 7 im Vakuum bei erhöhter Temperatur und unter mechanischem Druck verpresst wird. Durch ciese Pressung füllt der Kleber die Hohlräume zwischen den Erhöhungen 5 blasenfrei aus und wird ausgehärtet. Dabei muss die Dicke der Kleberfolie 6 derart auf das Erhöhungsmuster der Kupferfolie 1 abgestimmt sein, dass die Hohlräume ganz mit Kleber gefüllt werden und zwischen den Erhöhungen 5 und der aufgepressten Kupferfolie 7 eine Schicht Kleber verbleibt, die die Erhöhungen 5 und die Kupferfolie 7 voneinander trennt. **Figur 7** zeigt das verpresste Produkt.

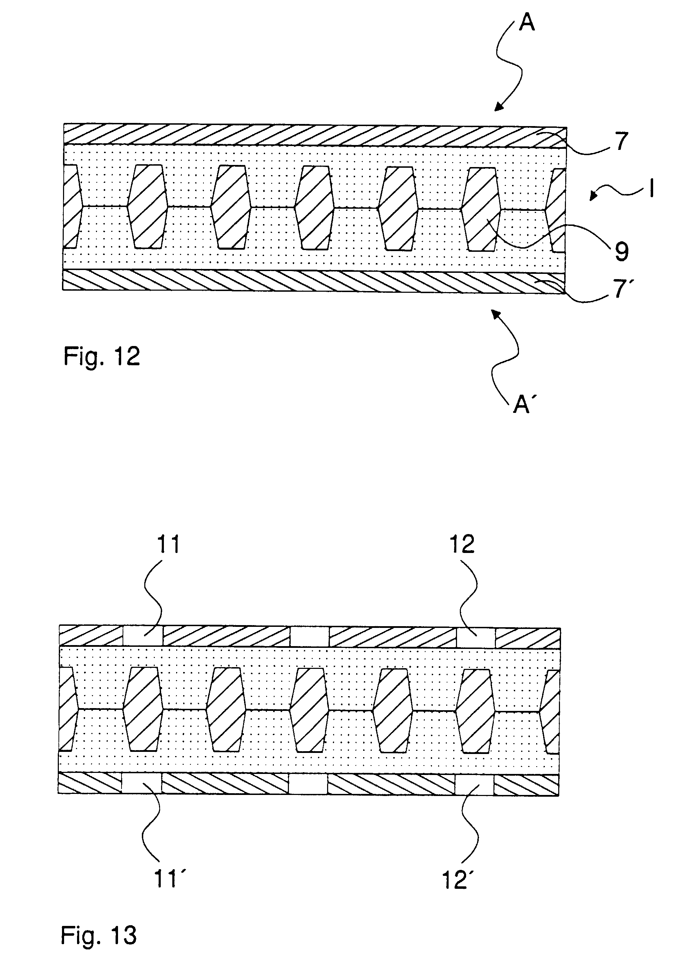

Es folgt nun die analoge Verarbeitung der anderen Seite der Kupferfolie 1, was in den **Figuren 8 bis 12** dargestellt ist, wobei gleiche Einheiten mit gleichen apostrophierten Bezugsziffern bezeichnet sind. **Figur 12** zeigt den beidseitig fertiggestellten Kern, in dem nun die beidseitigen Erhöhungen 5 und 5' Kupfersäulen 9 bilden, die durch den ausgehärteten Kleber 6 elektrisch voneinander und von den aufgepressten Kupferfolien 7, 7' isoliert sind. Dies ist die einfachste Ausführungsform des erfindungsgemässen Kerns, bestehend aus einer Innenschicht I mit Säulen 9 in einer Matrix und beidseitigen metallischen Deckschichten A und A'.

Die Form der Säulen (9) ist vom Ausgangsmaterial, von der Form und der gegenseitigen Anordnung der Resistinseln und von den Ätzparametern abhängig. Bei der Verarbeitung von Compositfolien aus Cu-Al-Cu, an denen die mittlere Aluminiumschicht beim Ätzen stärker angegriffen wird als die äusseren Kupferschichten, entstehen entsprechend stufenartig geformte Säulen.

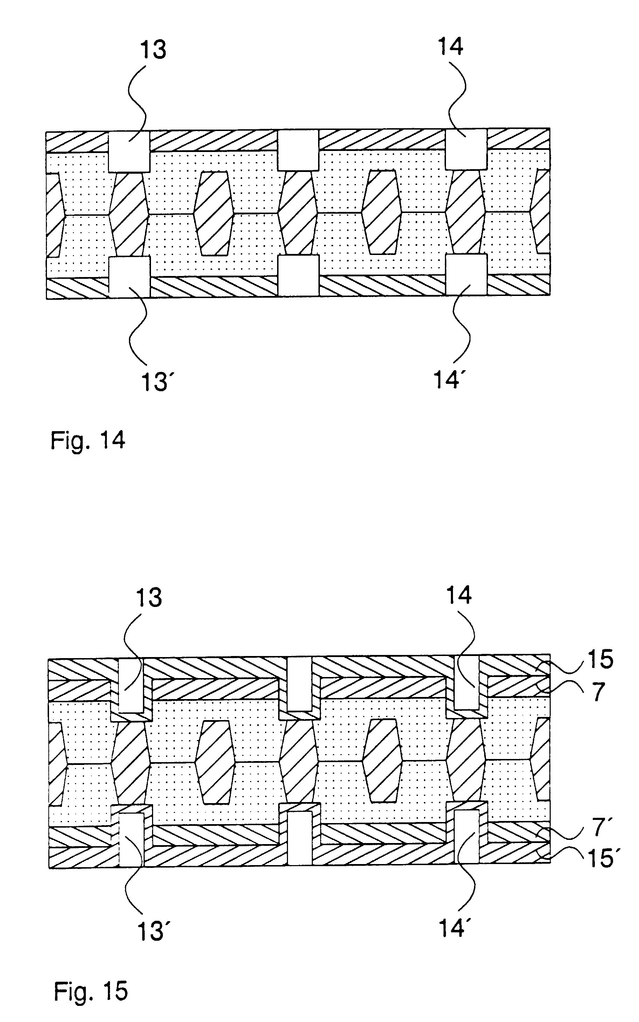

Die äusseren Kupferschichten 7 und 7' können nun photochemisch weiter strukturiert werden, indem beidseitig über jenen Kupfersäulen, die als Z-Verbindungen dienen sollen, Paare von Fenstern 11/11', 12/12' in die Kupferschichten 7, 7' geätzt werden, wie dies in der **Figur 13** erkennbar ist. Dies kann für eine individuelle Anwendung nach einem dadurch gegebenen Muster oder nach einem universellen, regelmässigen Muster geschehen. Der Kern wird dann einem Plasmaätzschritt unterzogen, in dem an den freigelegten Stellen 11, 11', 12, 12' die isolierende Schicht über den Säulen entfernt wird und dadurch, wie in **Figur 14** sichtbar, Paare von Sacklöchern 13/13', 14/14' auf die Säulen entstehen. In einem darauf folgenden, galvanischen Durchplattierungsschritt wird der Kern beidseitig mit einer Metallschicht 15, 15' überzogen, die, wie in **Figur 15** gezeigt, durch die durchplattierten Sacklöcher 13, 13', 14, 14' und die ausgewählten Säulen elektrisch miteinander verbunden sind.

Die Sacklöcher auf die Säulen können selbstverständlich auch durch andere Methoden als Trockenätzen hergestellt werden, also beispielsweise durch mechanisches Bohren oder Laserbohren mit entsprechender Anpassung der vorgängigen Schritte.

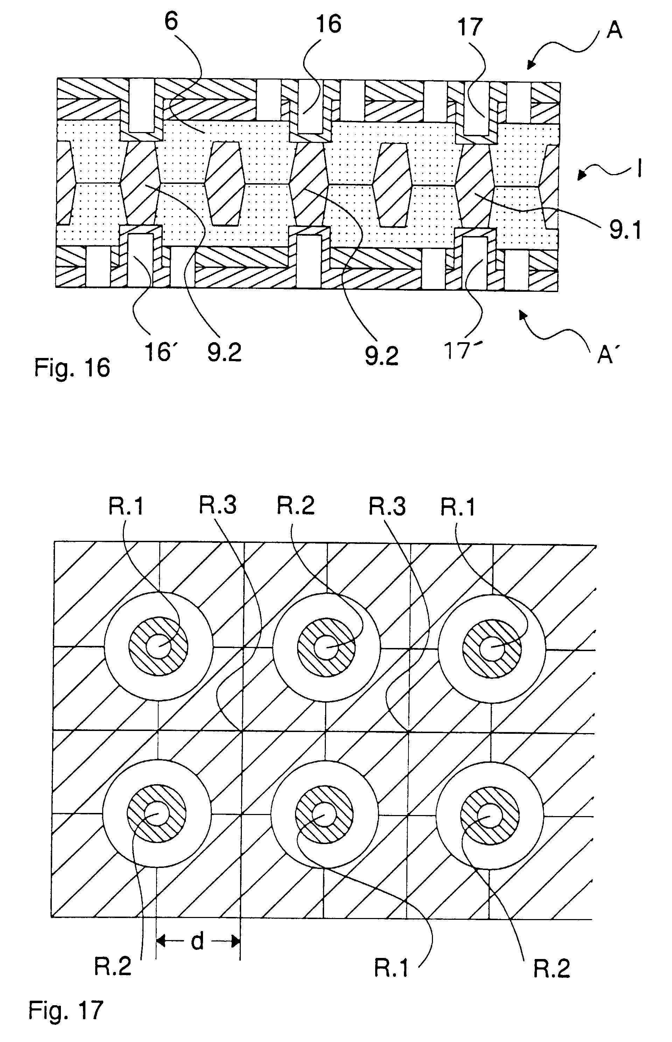

Der in **Figur 15** gezeigte Kern kann nun für eine individuelle Anwendung weiter verarbeitet werden durch entsprechende photochemische Strukturierung der metallischen Deckschichten A und A' (15/7 und 15'/7') zu Leiterebenen. Diese photochemische Strukturierung kann aber ebenfalls universell durchgeführt werden, wie dies in der **Figur 16** gezeigt ist. Dabei werden die beiden Deckschichten A und A' beispielsweise zu Serviceebenen strukturiert, die von einem regelmässigen Muster von Anschlüssen 16, 16' an die gegenüberliegende Serviceebene (über Säulen 9.2) und Anschlüssen 17, 17' an von den Serviceebenen isolierte Z-Verbindungen (Durchsteiger, Säulen 9.1) durchsetzt sind.

**Figur 17** zeigt als Draufsicht die eine Oberfläche eines Kernes gemäss Figur 16. Diese zeigt ein regelmässiges Rastermuster, das ein Rastermass d von vorzugsweise <2 mm, beispielsweise 0,5 mm haben kann. Die Rasterpunkte R.1, R.2, R.3 sind dabei regelmässig ausgenützt, wobei Rasterpunkte R.1 Anschlüsse auf die gegenüberliegende Serviceebene (16, Figur 16), Rasterpunkte R.2 Anschlüsse für Durchsteiger (17, Figur 16) und Rasterpunkte R.3 potentielle Anschlüsse auf die sichtbare Serviceebene, die keine spezielle Strukturierung erfordern, sind.

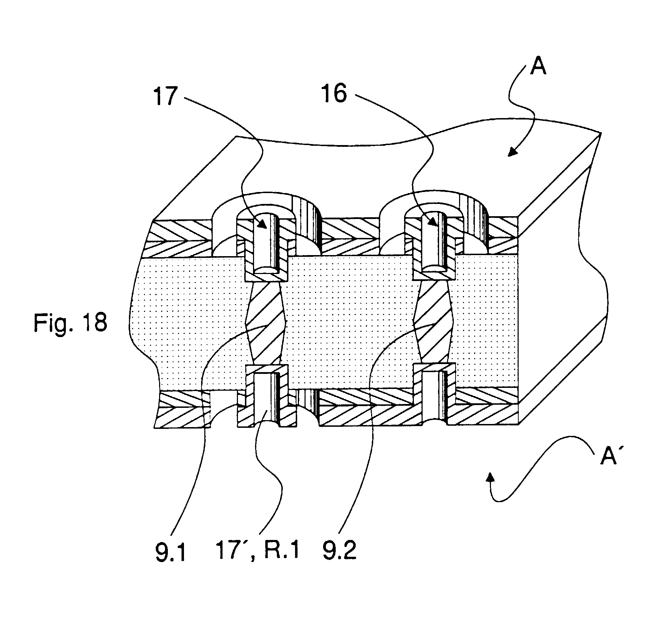

**Figur 18** zeigt eine Ansicht auf einen Bereich eines geschnittenen Kerns gemäss Figur 16, der eine Z-Verbindung für eine potentielle Signalverbindung (Säule 9.1 mit Anschlüssen 17 und 17') und eine Z-Verbindung für einen Anschluss an die gegenüberliegende Serviceebene (Säule 9.2, Anschluss 16) aufweist.

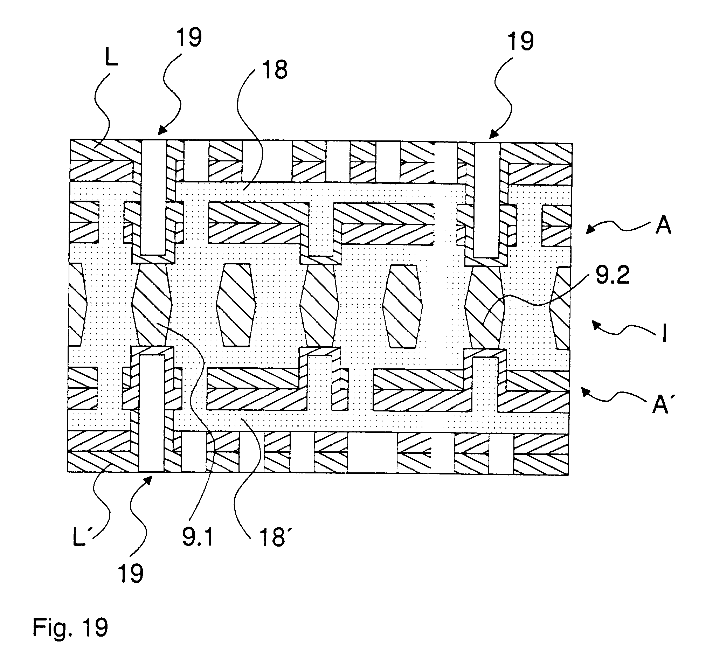

**Figur 19** zeigt noch einen Querschnitt durch einen Bereich einer beispielhaften Leiterplatte mit einem Kern gemäss Figur 16, bestehend aus einer Innenschicht I und metallischen, strukturierten Deckschichten A und A'. Die Leiterplatte weist beidseitig vom Kern je eine Folienlage auf, die aus einer elektrisch isolierenden Schicht 18, 18' und einer Leiterebene L, L' besteht. Durch entsprechende durchplattierte Sacklöcher 19 werden wahlweise Anschlussstellen des Anschlussrasters auf dem Kern kontaktiert.

Eine Folienleiterplatte gemäss Figur 19 wird beispielsweise hergestellt, indem auf einen Kern gemäss Figur 16 mit Hilfe je einer Kleberfolie beidseitig eine Kupferfolie oder eine mit Kupfer beschichtete Kunststoffolie auflaminiert wird. Durch einen ersten photochemischen Prozess wird dann die aussenliegende Metallschicht an denjenigen Stellen, an denen Sacklöcher auf den Kern vorgesehen sind, weggeätzt. Dann werden durch Plasmaätzen die Sacklöcher erstellt und durch nachfolgende galvanische Behandlung die Sacklöcher durchplattiert und die Metallschichten aufgebaut. In die daraus resultierenden metallischen Beschichtungen werden wiederum mit bekannten photochemischen Prozessen Leitermuster eingeätzt.

## Patentansprüche

1. Kernschicht zur Weiterverarbeitung für elektrische Verbindungssubstrate, insbesondere Leiterplatten und Folienleiterplatten mit beidseitigen Leiterebenen, wobei die Kernschicht eine Innenschicht (I) mit einer Anordnung von elektrisch isolierten Säulen (9) aus einem elektrisch leitfähigen Material aufweist, welche Innenschicht (I) beidseitig mit metallischen Deckschichten (A,A') abgedeckt ist, **dadurch gekennzeichnet,** dass
die elektrisch isolierten Säulen (9) voneinander beabstandet angeordnet und vom elektrisch isolierenden Material der Innenschicht (I) vollständig umhüllt sind
und das für die Innenschicht (I) verwendete Material von Deckschicht zu Deckschicht reicht.

2. Kernschicht nach Anspruch 1, **dadurch gekennzeichnet,** dass die Säulenanordnung regelmässig ist.

3. Kernschicht nach einem der Ansprüche 1 oder 2, **dadurch gekennzeichnet,** dass das elektrisch leitende Material der Säulen Kupfer, Cu-Al-Cu, Stahl, Messing, Bronze, eine Al-Mg-Legierung, Invar oder Molybdän ist und dass das elektrisch isolierende Material ein aushärtbarer Kunststoff ist.

4. Kernschicht nach einem der Ansprüche 1 bis 3, **dadurch gekennzeichnet,** dass die metallischen Deckschichten (A, A') zu Leiterebenen strukturiert sind, die durch durchplattierte Sacklöcher (13, 14) durch das elektrisch isolierende Material hindurch mit ausgewählten Säulen (9) der Innenschicht (I) leitend verbunden sind.

5. Kernschicht nach Anspruch 4, **dadurch gekennzeichnet,** dass die zu Leiterebenen strukturierten Deckschichten (A, A') als Serviceebenen ausgebildet sind, dadurch, dass ihre Struktur und die Positionen der durchplattierten Sacklöcher (13, 14) derart sind, dass ein Teil der Säulen (9.2) Z-Verbindungen, d.h. elektrische Durchführungen in Z-Richtung für Anschlüsse auf der einen Kernseite zur Serviceebene der gegenüberliegenden Kernseite und ein Teil der Säulen (9.1) von beiden Serviceebenen elektrisch getrennte Z-Verbindungen durch die Kernschicht bilden.

6. Kernschicht nach Anspruch 5, **dadurch gekennzeichnet,** dass die Anschlüsse (16, 16') an Z-Verbindungen zu der gegenüberliegenden Serviceebene und die Anschlüsse (17, 17') an von den Serviceebenen beidseitig isolierten Z-Verbindungen auf beiden Kernaussenseiten in einem regelmässigen Raster angeordnet sind.

7. Kernschicht nach Anspruch 6, **dadurch gekennzeichnet,** dass der Raster ein Rastermass (d) von <2 mm aufweist.

8. Elektrisches Verbindungssubstrat mit einer Kernschicht nach einem der Ansprüche 1 bis 7, **dadurch gekennzeichnet** dass es beidseitig von der Kernschicht Leiterebenen aufweist und dass Leiter dieser Leiterebenen durch die Säulen der Kernschicht elektrisch miteinander verbunden sind.

9. Elektrisches Verbindungssubstrat nach Anspruch 8, **dadurch gekennzeichnet,** dass es beidseitig auf der Kernschicht mindestens eine Folienlage bestehend aus einer elektrisch isolierenden Schicht (18, 18') und einer Leiterebene (L, L') aufweist, wobei mindestens die beiden der Kernschicht am nächsten liegenden Leiterebenen durch durchplattierte Sacklöcher (19) durch die isolierende Schicht (18, 18') mit ausgewählten Säulen (9.1, 9.2) der Innenschicht (I) der Kernschicht elektrisch verbunden sind.

10. Elektrisches Verbindungssubstrat nach Anspruch 9, **dadurch gekennzeichnet,** dass die beiden Serviceebenen (A, A') der Kernschicht mit Erde und mit einer Speisespannung beschaltbar sind.

11. Verfahren zur Herstellung einer Kernschicht für elektrische Verbindungssubstrate nach einem der Ansprüche 1 bis 7, **gekennzeichnet** durch die folgenden Verfahrensschritte:
a) Metallfolie (1) beidseitig mit Photoresist (2, 2') beschichten;
b) Photoresist der einen Seite belichten und entwickeln, derart, dass ein vorgegebenes Muster von Photoresistinseln (3) entsteht;
c) beschichtete Metallfolie nassätzen, derart, dass an den freiglegten Stellen etwa die Hälfte der Metalldicke weggeätzt wird und Erhöhungen (5) entstehen;
d) Photoresist beidseitig strippen;
e) geätzte Metalloberfläche mit einer Kleberfolie (6) aus aushärtbarem Kunststoff und einer Metallfolie (7) belegen;
f) im Vakuum und erhöhter Temperatur durch mechanischen Druck verpressen;
g) Verfahrensschritte a bis f zur Bearbeitung der anderen Seite in analoger Weise wiederholen, derart, daß die beidseitigen Erhöhungen (5,5') die Säulen (9) bilden.

12. Verfahren nach Anspruch 11, **gekennzeichnet** durch die zusätzlichen Verfahrnsschritte:
h) Sacklöcher durch die aussenliegenden Metallschichten (7, 7') auf Säulen (9) der Säulenstruktur herstellen;
i) durch diese Sacklöcher zwischen äusseren Metallschichten und Säulen elektrische Verbindungen herstellen.
k) beidseitige metallische Schichten (7/15, 7'/15') photochemisch zu einem vorgegebenen Muster strukturieren, derart, dass die Oberflächen der Kernschicht Anschlüsse (16) zu Z-Verbindungen zur gegenüberliegenden metallischen Schicht und Anschlüsse (17) zu Z-Verbindungen, die von diesen metallischen Schichten isoliert sind, aufweisen.

13. Verfahren nach Anspruch 12, **dadurch gekennzeichnet,** dass die Verfahrensschritte h) und i) durchgeführt werden durch:
h) aussenliegende Metallschichten (7, 7') der Kernschicht photochemsch derart strukturieren, dass in einem regelmässigen Muster an Stellen (11, 12, 11', 12') über ausgewählten Säulen die Kunststoffoberfläche freigelegt wird;
h') Kernschicht trockenätzen, derart, dass an den freigelegten Stellen auf die Säulen reichende Sacklöcher (13, 13', 14, 14') entstehen;
i) Kernschicht derart galvanisch behandeln, dass er beidseitig mit einer weiteren Metallschicht (15, 15') bedeckt wird.

14. Verfahren zur Herstellung eines elektrischen Verbindungssubstrates nach einem der Ansprüche 8 bis 10, **dadurch gekennzeichnet,** dass auf die Kernschicht beidseitig mit Hilfe je einer Kleberfolie aus einem aushärtbaren Kunststoff eine Metallfolie oder eine mit Metall beschichtete Kunststoffolie auflaminiert wird, dass durch photochemische Bearbeitung der dadurch gebildeten, aussenliegenden Metallschichten und nachträgliches Plasmaätzen Sacklöcher durch die Kleberfolie oder die Kleberfolie und die Kunststoffolie auf die Anschlussstellen auf den Serviceebenen der Kernschicht hergestellt werden, dass diese Sacklöcher durchplattiert werden und dass anschliessend die aussenliegenden Metallschichten photochemisch strukturiert werden.

## Claims

1. Core layer for further processing for electrical connection substrates, in particular printed circuit boards and flexible printed circuits with conductor layers on both sides, the core layer having an inner layer (I) with an arrangement of electrically insulating columns (9) made of an electrically conductive material, which inner layer (I) is covered on both sides by metallic covering layers (A, A'), characterized in that the electrically insulating columns (9) are arranged spaced apart from one another and are completely surrounded by the electrically insulating material of the inner layer (I), and the material which is used for the inner layer (I) extends from covering layer to covering layer.

2. Core layer according to Claim 1, characterized in that the column arrangement is regular.

3. Core layer according to one of Claims 1 or 2, characterized in that the electrically conductive material of the columns is copper, Cu-Al-Cu, steel, brass, bronze or an Al-Mg alloy, invar or molybdenum, and in that the electrically insulating material is a curable plastic.

4. Core layer according to one of Claims 1 to 3, characterized in that the metallic covering layers (A, A') are structured to form conductor layers which are conductively connected through through-plated blind holes (13, 14) through the electrically insulating material to selected columns (9) in the inner layer (I).

5. Core layer according to claim 4, characterized in that the covering layers (A, A') which are structured to form conductor layers are designed as service layers, by virtue of the fact that their structure and the positions of the through-plated blind holes (13, 14) are such that some of the columns (9.2) form Z-connections, that is to say electrical bushings in the Z-direction, for connections on one core side for the service layer of the opposite core side, and some of the columns (9.1) form Z-connections through the core layer which are electrically isolated from both service layers.

6. Core layer according to Claim 5, characterized in that the connections (16, 16') to Z-connections for the opposite service layer, and the connections (17, 17') to Z-connections which are insulated from the service layers on both sides are arranged in a regular grid pattern on both core outer sides.

7. Core layer according to Claim 6, characterized in that the grid pattern has a grid size (d) of <2 mm.

8. Electrical connection substrate having a core layer according to one of Claims 1 to 7, characterized in that said substrate has conductor layers on both sides of the core layer, and in that conductors in these conductor layers are electrically connected to one another by means of the columns in the core layer.

9. Electrical connection substrate according to Claim 8, characterized in that said substrate has at least one flexible layer on both sides of the core layer, comprising an electrically insulating layer (18, 18') and a conductor layer (L, L'), at least the two conductor layers which are located closest to the core layer being electrically connected by means of through-plated blind holes (19) through the insulating layer (18, 18') to selected columns (9.1, 9.2) in the inner layer (I) of the core layer.

10. Electrical connection substrate according to Claim 9, characterized in that the two service layers (A, A') of the core layer can be connected to earth and to a supply voltage.

11. Method for producing a core layer for electrical connection substrates according to one of Claims 1 to 7, characterized by the following method steps:
a) the metal sheet (1) is coated on both sides with photoresist (2, 2');
b) the photoresist on one side is exposed and developed, in such a manner that a predetermined pattern of photoresist islands (3) is produced;
c) the coated metal sheet is wet-etched, in such a manner that approximately half the metal thickness is etched away at the exposed points and projections (5) are produced;
d) the photoresist is stripped on both sides;
e) the etched metal surface is coated with an adhesive film (6) composed of curable plastic and a metal sheet (7);
f) compression is carried out by mechanical pressure in a vacuum and at a raised temperature;
g) method steps a to f are repeated in an analogous manner for processing of the other side, in such a manner that the projections (5, 5') on both sides form the columns (9).

12. Method according to Claim 11, characterized by the additional method steps:
h) blind holes are produced through the externally located metal layers (7, 7') on columns (9) of the column structure;
i) electrical connections are produced through these blind holes between the outer metal layers and the columns.
k) metallic layers (7/15, 7'/15') on both sides are photochemically structured to form a predetermined pattern, in such a manner that the surfaces of the core layer have connections (16) to form Z-connections for the opposite metallic layer and connections (17) to form Z-connections which are insulated from these metallic layers.

13. Method according to Claim 12, characterized in that the method steps h) and i) are carried out by:
h) photochemically structuring externally located metal layers (7, 7') of the core layer in such a manner that the plastic surface is exposed in a regular pattern at points (11, 12, 11', 12') above selected columns;
h') dry etching the core layer in such a manner that blind holes (13, 13', 14, 14') which extend at the exposed points as far as the columns are produced;
i) electrochemically treating the core layer in such a manner that it is covered on both sides by a further metal layer (15, 15').

14. Method for producing an electrical connection substrate according to one of Claims 8 to 10, characterized in that a metal sheet or a plastic sheet which is coated with metal is laminated onto the core layer on both sides, with the aid of in each case one adhesive sheet composed of a curable plastic, in than blind holes are produced through the adhesive sheet or the adhesive sheet and the plastic sheet to the connection points on the service layers of the core layer by photochemical processing of the externally located metal layers formed in this way and subsequent plasma etching, in that these blind holes are through-plated, and in that, subsequently, the externally located metal layers are photochemically structured.

## Revendications

1. Couche centrale destinée à un traitement ultérieur pour des substrats de liaison électriques, en particulier des circuits imprimés et des circuits imprimés souples avec des faces à conducteurs des deux côtés, la couche centrale comportant une couche intérieure (I) qui présente une disposition de piles (9) isolées électriquement et est recouverte des deux côtés de couches de recouvrement (A, A') métalliques, caractérisée en ce que les piles (9) isolées électriquement sont disposées à distance l'une de l'autre et sont enveloppées entièrement par le matériau isolant électriquement de la couche intérieure (I) et en ce que le matériau utilisé pour la couche intérieure (I) va d'une couche de recouvrement à une couche de recouvrement.

2. Couche centrale selon la revendication 1, caractérisée en ce que la disposition de piles est régulière.

3. Couche centrale selon la revendication 1 ou 2, caractérisée en ce que le matériau électriquement conducteur des piles est du cuivre, Cu-Al-Cu, de l'acier, du laiton, du bronze, un alliage Al-Mg, de l'invar ou du molybdène et en ce que le matériau électriquement isolant est un plastique durcissable.

4. Couche centrale selon l'une quelconque des revendications 1 à 3, caractérisée en ce que les couches de recouvrement (A, A') métalliques sont structurées en faces à conducteurs qui sont reliées de manière conductrice aux piles (9) sélectionnées de la couche intérieure (I), par des trous borgnes (13, 14) métallisés et réalisés à travers le matériau électriquement isolant.

5. Couche centrale selon la revendication 4, caractérisée en ce que les couches de recouvrement (A, A') structurées en faces à conducteurs sont conçues en tant que faces de service, en ce que leur structure et les positions des trous borgnes (13, 14) métallisés sont de telle sorte qu'une partie des piles (9.2) forme des liaisons Z, c'est à dire des passages électriques dans le sens Z, pour des jonctions sur l'un des côtés du noyau central vers la face de service du côté du noyau central opposé et en ce qu'une partie des piles (9.1) forme des liaisons Z séparées électriquement par les deux faces de service, à travers la couche centrale.

6. Couche centrale selon la revendication 5, caractérisée en ce que les jonctions (16, 16') avec les liaisons Z vers la face de service opposée et les jonctions (17, 17') avec les liaisons Z isolées des deux côtés par les faces de service sont disposées sur les deux côtés extérieurs du noyau central dans une grille régulière.

7. Couche centrale selon la revendication 6, caractérisée en ce que la grille présente une dimension de grille (d) < 2 mm.

8. Substrat de liaison électrique comportant une couche centrale selon l'une quelconque des revendications 1 à 7, caractérisé en ce qu'il présente des deux côtés de la couche centrale, des faces à conducteurs et en ce que les conducteurs de ces faces à conducteurs sont reliés électriquement l'un à l'autre par les piles de la couche centrale.

9. Substrat de liaison électrique selon la revendication 8, caractérisé en ce qu'il présente des deux côtés de la couche centrale, au moins une couche souple comportant une couche (18, 18') électriquement isolante et une face à conducteurs (L, L'), au moins les deux faces à conducteurs les plus proches de la couche centrale étant reliées électriquement aux piles (9.1, 9.2) sélectionnées de la couche intérieure (I) de la couche centrale, par des trous borgnes (19) métallisés traversant la couche (18, 18') isolante.

10. Substrat de liaison électrique selon la revendication 9, caractérisé en ce que les deux faces de service (A, A') de la couche centrale peuvent être connectées à la terre et à une tension d'alimentation.

11. Procédé de fabrication d'une couche centrale pour des substrats de liaison électriques selon l'une quelconque des revendications 1 à 7, caractérisé par les étapes de procédé suivantes :
a) enduire des deux côtés une feuille métallique (1) de laque photosensible (2, 2') ;
b) exposer la laque photosensible d'un côté et développer de telle sorte qu'il se forme un modèle prédéfini d'îlots de laque photosensible (3) ;
c) graver par voie humide la feuille métallique enduite de telle sorte qu'aux endroits mis à nu, à peu près la moitié de la couche métallique soit enlevée par gravure et qu'il se forme des élévations (5) ;
d) stripper des deux côtés la laque photosensible ;
e) revêtir la surface métallique gravée d'une feuille adhésive (6) en plastique durcissable et d'une feuille métallique (7) ;
f) comprimer sous vide et à température élevée par pression mécanique ;
g) répéter de manière analogue les étapes de procédé a à f pour le traitement de l'autre côté de telle sorte que les élévations (5, 5') des deux côtés forment les piles (9).

12. Procédé selon la revendication 11, caractérisé par les étapes de procédé supplémentaires :
h) réaliser des trous borgnes à travers les couches métalliques (7, 7') extérieures, sur les piles (9) de la structure à piles ;
i) établir des liaisons électriques à travers ces trous borgnes entre les couches métalliques extérieures et les piles ;
k) structurer par voie photochimique les deux côtés des couches métalliques (7/15, 7'/15') en un modèle prédéfini de telle sorte que les surfaces de la couche centrale présentent des jonctions (16) avec les liaisons Z vers la couche métallique opposée et des jonctions (17) avec les liaisons Z qui sont isolées par ces couches métalliques,

13. Procédé selon la revendication 12, caractérisé en ce que les étapes de procédé h et i) sont réalisées comme suit :
h) structurer par voie photochimique les couches métalliques (7, 7') extérieures de la couche centrale de telle sorte que la surface en plastique soit mise à nu selon un modèle régulier, aux endroits (11, 12, 11', 12') au-dessus des piles sélectionnées ;
h') graver à sec la couche centrale de telle sorte qu'aux endroits mis à nu, il se forme des trous borgnes (13, 13', 14, 14') s'étendant sur les piles ;
i) traiter la couche centrale galvaniquement de telle sorte qu'elle soit recouverte des deux côtés d'une autre couche métallique (15, 15').

14. Procédé de fabrication d'un substrat de liaison électrique selon l'une quelconque des revendications 8 à 10, caractérisé en ce qu'une feuille métallique ou une feuille plastique revêtue de métal est laminée sur la couche centrale, des deux côtés, au moyen respectivement d'une feuille adhésive réalisée dans un plastique durcissable, en ce que par un traitement photochimique des couches métalliques extérieures formées ainsi et par une gravure ultérieure au plasma, des trous borgnes Sont réalisés à travers la feuille adhésive ou la feuille adhésive et la feuille plastique, aux points de jonction sur les faces de service de la couche centrale, en ce que ces trous borgnes sont métallisés et en ce que les couches métalliques extérieures sont ensuite structurées par voie photochimique.
